# EUROPEAN PATENT SPECIFICATION

(11) **EP 3 561 172 B1**
(45) Date of publication and mention of the grant of the patent: **30.10.2024**
(21) Application number: 19178768.8
(22) Date of filing: 02.06.2014
(51) Int. Cl.: D06F 39/14, D06F 39/12, D06F 34/34, D06F 25/00, D06F 34/28, D06F 39/02, D06F 58/20

(54) **LAUNDRY TREATING APPARATUS COMPRISING A DOOR**
WÄSCHEBEHANDLUNGSVORRICHTUNG MIT EINER TÜR
APPAREIL DE TRAITEMENT DU LINGE AVEC UNE PORTE

(30) Priority: 04.06.2013 KR 20130064077; 18.04.2014 KR 20140046922
(43) Date of publication of application: 30.10.2019
(62) Divisional of application: 14170780.2
(73) Proprietor: LG Electronics Inc., Seoul 07336 (KR)
(72) Inventor: Han, Jonghee, Seoul 153-802 (KR); Yang, Jinho, Seoul 153-802 (KR); Seong, Jaeseok, Seoul 153-802 (KR); You, Jungsang, Seoul 153-802 (KR); Choi, Jaehoon, Seoul 153-802 (KR); Ha, Youngsoo, Seoul 153-802 (KR); Lee, Kyungah, Seoul 153-802 (KR)
(74) Representative: Ter Meer Steinmeister & Partner

(56) References cited:
- EP-A1- 1 529 873
- EP-A1- 2 380 479
- WO-A1-02/22937
- DE-A1- 102011 078 920
- JP-A- 2012 183 108
- JP-A- 2012 223 344
- KR-A- 20090 005 486
- US-A1- 2008 289 940
- US-A1- 2013 014 546

## Description

### BACKGROUND OF THE INVENTION

### 1. Field of the invention

The present invention relates to a laundry treating apparatus. More specifically, the present invention relates to a laundry treating apparatus for washing or drying laundry.

### 2. Description of the Related Art

In general, the laundry treating apparatus has a concept of an apparatus for washing or drying laundry, such as clothes, or an apparatus for performing both washing and drying the laundry.

The laundry treating apparatus may include a cabinet having a laundry opening, a tub in the cabinet for holding washing water, a drum rotatably provided in the tub, a water supply unit for supplying the washing water to the tub, and a detergent supply unit for supplying detergent to the tub through the washing water being provided from the water supply unit.

KR 2009 0005486 A presents a washing machine to enable a user to open and shut a door easily by putting a door handle on the upper part of the washing machine. The washing ma-chine comprises: a main body including an opening on one side; a door which opens and closes the opening; a door handle on the door; a door locking unit which is operated according to an operation of the door handle and locks and unlocks the door. A central part of the door handle is characterized by being located on the upper part of the door locking unit.

US 2008/289940 A1 presents a washing machine, a control panel assembly of which has an improved structure to minimize problems caused by a shaking of a rotary knob and the interference of the rotary knob with other surrounding parts. The control panel assembly of the washing machine includes a control panel; a knob guide installed on the control panel; and a rotary knob rotatably mounted on the knob guide and including a boss passing through the knob guide. The knob guide includes a boss insertion part restricting the boss to prevent the rotary knob from shaking. The boss insertion part includes an extension extended from the bottom surface of the knob guide and forming a boss insertion hole, into which the boss is inserted, therein.

DE 10 2011 078920 A1 presents loading door for a laundry treatment machine with a door frame and with a decorative ring, which by means of corresponding door frame side and decorative ring-side connecting elements with the door frame is detachably connectable. The connecting elements by a rotational movement of the decoration ring relative to the door frame come into connecting engagement, another rotational movement of the decoration ring relative to the door frame the connecting elements disengages again and at least one releasable fixing element, if necessary, the further rotational movement prevented.

EP 1 529 873 A1 relates to reinforcement for the top plate of a drum washing machine.

US 2013/014546 A1 presents a drum-type washing machine that includes left and right side plates defining side surfaces of an outer case. A plurality of concave portions are formed on the left and right side plates, and the concave portion closer to a front surface of the outer case as a door side has an arc shape with a larger curvature. Thus, rigidity of the side plates in the up and down direction and the left and right direction is increased, so that vibration at the time of spin-drying is reduced.

JP 2012 183108 A presents a removal device having a structure for achieving easy removal of lint and a drying device incorporating the removal device.

JP 2012 223344 A relates to a washing and drying machine having an openable/closable lid provided on the front side of the rotary drum.

WO 02/22937 A1 relates to a method of manufacturing a laundry appliance.

EP 2 380 479 A1 describes a metal cover covering a front side and a side surfaces of a plastic housing, the cover having a hole for mounting a display. Operating keys on the metal cover are operated by touch on the metal surface.

### SUMMARY OF THE INVENTION

An object of the present invention is to provide a laundry treating apparatus which enables high utilization of an inside space, to take easy notice of information, and easy operation.

It is another object of the present invention to provide a laundry treating apparatus which can improve degrees of freedom of fabrication of a control panel.

### Technical Solution

The invention is set out by the features of the independent claim.

To achieve the objects of the present invention, a laundry treating apparatus includes a cabinet having a laundry opening formed therein, a door mounted to the cabinet for opening/closing the laundry opening, and a control panel arranged at the cabinet, wherein the control panel includes a control panel body projected forward from a front plate, and a front side of the control panel body is sloped to face upward.

The control panel body may further include an upper side, a lower side and two opposite sides exposed to an outside of the laundry treating apparatus.

The control panel body may have a front/rear direction width of the lower side larger than a front/rear direction width of the upper side.

The control panel body may have a vertical direction height smaller than a vertical direction height of the front plate.

The control panel body may include a front body portion projected forward from the front plate, and a window arranged at the front body portion to have the front side sloped to face upward.

The control panel body may further include a deco which surrounds a circumference of the front body portion and a circumference of the window, altogether.

The front body portion may have a space formed therein, and the control panel may further include a PCB assembly having at least a portion thereof inserted in the space.

The control panel may include a PCB assembly arranged to pass through an opening formed in the front plate, and the control panel body may include a window arranged at the PCB assembly to have a front side sloped to face upward, and a deco which surrounds a circumference of the PCB assembly and a circumference of the window, altogether.

The door has a portion facing a lower side of the control panel body in a vertical direction.

A gap between the control panel body and the door is smaller than a height of the control panel body.

The door has an outer frame which forms an exterior appearance of the door, wherein the outer frame is positioned such that at least a portion of the outer frame is projected to an outside of the cabinet when the door is closed.

The outer frame has an outside circumferential surface having a hand grip formed thereon.

The hand grip includes a recess formed in the outside circumferential surface of the outer frame.

The outer frame has a hand grip formed thereon facing the lower side of the control panel body in a vertical direction of the door.

When the door is closed, the door may have a largest projected width in a front/rear direction larger than a largest projected width in a front/rear direction of the control panel body.

When the door is closed, the control panel body may have a largest projected width in a front/rear direction the same with a largest projected width in a front/rear direction of the door, substantially.

The laundry treating apparatus further includes a drawer panel arranged at the control panel, wherein the drawer panel has a sloped side positioned on the same plane with the front side of the control panel body, substantially.

The drawer panel may include a drawer hand grip having the sloped side.

The drawer panel may have a hand grip space having an opened lower side in rear of the drawer hand grip, wherein the hand grip space may face a portion of an outside circumferential surface of the door when the door is closed.

The laundry treating apparatus further includes a drawer panel arranged at the control panel, wherein the drawer panel may include a drawer body portion projected forward, and a drawer cover arranged at the drawer body portion to have a sloped side positioned on the same plane with the front side of the control panel body, substantially.

The drawer panel may further include a drawer deco surrounding an upper side, a left side and a right side of the front body portion and a circumference of the drawer cover, altogether.

In another aspect of the present invention, a laundry treating apparatus includes a cabinet which forms an exterior appearance of the laundry treating apparatus, and a display positioned on an upper side of the cabinet in front of a front side of the cabinet to have a front side sloped to face upward.

The laundry treating apparatus further includes a drawer panel having a sloped side positioned on the same plane with the front side of the display.

The sloped side may be positioned on a side of the front side of the display.

The laundry treating apparatus may further includes a door mounted to the cabinet, wherein the door may have a projected width the same with the display, substantially.

The display, the door and the drawer panel are projected forward from the cabinet.

The laundry treating apparatus of the present invention has the following advantages.

The outward projection of the control panel body can enhance degrees of freedom of fabrication of the control panel.

And, the projection of the outer frame of the door to the outside of the cabinet can enhance degrees of freedom of fabrication and a shape of the door.

And, utilization of the inside of the cabinet can be enhanced.

And, a distance between a lower side of a front side of the control panel body and eyes of the user can be minimized, enabling the user to notice information which the control panel displays more easily.

And, the availability of handling of the control panel body in a sloped direction enables the user, standing in front of the laundry treating apparatus, to handle the control panel conveniently and easily without giving overstrain to a wrist of the user.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a perspective view illustrating a laundry treating apparatus in accordance with a first preferred embodiment of the present invention;
FIG. 2 is a front view illustrating a laundry treating apparatus in accordance with a first preferred embodiment of the present invention;
FIG. 3 is a side view illustrating a laundry treating apparatus in accordance with a first preferred embodiment of the present invention;
FIG. 4 is a plan view illustrating a laundry treating apparatus in accordance with a first preferred embodiment of the present invention;
FIG. 5 is a sectional view illustrating a laundry treating apparatus in accordance with a first preferred embodiment of the present invention;
FIG. 6 is a perspective view illustrating a front cover of a laundry treating apparatus in accordance with a first preferred embodiment of the present invention;
FIG. 7 is a front view illustrating a front cover of a laundry treating apparatus in accordance with a first preferred embodiment of the present invention;
FIG. 8 is a perspective view illustrating a rear side of a control panel of a laundry treating apparatus in accordance with a first preferred embodiment of the present invention;
FIG. 9 is a plan view illustrating a control panel of a laundry treating apparatus in accordance with a first preferred embodiment of the present invention;
FIG. 10 is a side view illustrating a control panel coupled to a front cover of a laundry treating apparatus in accordance with a first preferred embodiment of the present invention;
FIG. 11 is a perspective view illustrating an exterior appearance of a bottom side of a detergent supply unit of a laundry treating apparatus in accordance with a first preferred embodiment of the present invention;
FIG. 12 is a back side perspective view illustrating a hand grip of a laundry treating apparatus in accordance with a first preferred embodiment of the present invention;
FIG. 13 is a bottom side view illustrating a hand grip of a laundry treating apparatus in accordance with a first preferred embodiment of the present invention;
FIG. 14 is a perspective view illustrating a laundry treating apparatus in accordance with a first preferred embodiment of the present invention, showing a door opened;
FIG. 15 is a sectional view illustrating a door of a laundry treating apparatus in accordance with a first preferred embodiment of the present invention:
   FIG. 16 is a perspective view illustrating a laundry treating apparatus in accordance with a first preferred embodiment of the present invention, showing another example of a door opened;
   FIG. 17 is a perspective view illustrating a laundry treating apparatus in FIG. 16, with the door closed;
   FIG. 18 is a perspective view illustrating another example of a control panel body of a laundry treating apparatus in accordance with a first preferred embodiment of the present invention;
   FIG. 19 is a perspective view illustrating a laundry treating apparatus in accordance with a second preferred embodiment of the present invention;
   FIG. 20 is a front view illustrating a laundry treating apparatus in accordance with a second preferred embodiment of the present invention;
   FIG. 21 is a side view illustrating a laundry treating apparatus in accordance with a second preferred embodiment of the present invention;
   FIG. 22 is a plan view illustrating a laundry treating apparatus in accordance with a second preferred embodiment of the present invention;
   FIG. 23 is an exploded perspective view illustrating a control panel of a laundry treating apparatus in accordance with a second preferred embodiment of the present invention;
   FIG. 24 is an exploded perspective view illustrating a drawer panel of a laundry treating apparatus in accordance with a second preferred embodiment of the present invention; and
   FIG. 25 is a sectional view illustrating a control panel of a laundry treating apparatus in accordance with a third preferred embodiment of the present invention, schematically.

### DETAILED DESCRIPTION OF THE INVENTION

In what follows, a laundry treating apparatus according to preferred embodiments of the present invention will be described in detail with reference to the appended drawings.

The laundry treating apparatus in accordance with a first preferred embodiment of the present invention may be applicable both to a top loading type laundry treating apparatus having a laundry opening provided in a top side of a cabinet, and a front loading type laundry treating apparatus having the laundry opening provided in a front side (or, a side) of the cabinet. The specification will be described taking the front loading type laundry treating apparatus as an example.

And, the laundry treating apparatus includes all apparatuses which treats the laundry. In detail, the laundry treating apparatus includes a washing machine for removing contamination from the laundry by using washing water, a dryer for removing moisture from the laundry, and washer-dryer having a drying function.

And, the dryer may include a drum type dryer for supplying heated air to a rotatable drum to dry the laundry, and a cabinet type dryer (Refresher) for supplying the heated air to a clothes placing space in which the clothes are placed.

Though the embodiments of the present invention will be described taking the front loading type washing machine with a rotatable drum to which the laundry is introduced through the front side of the cabinet as an example, the embodiments of the present invention do not exclude various types of laundry treating apparatuses described before.

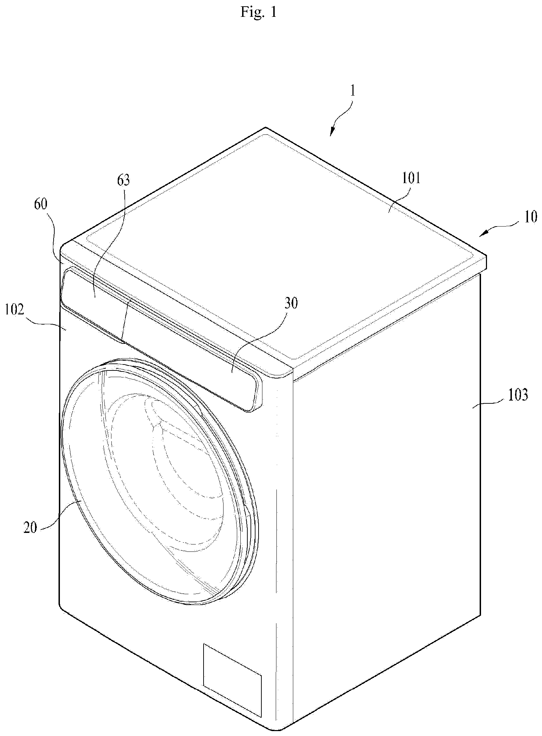

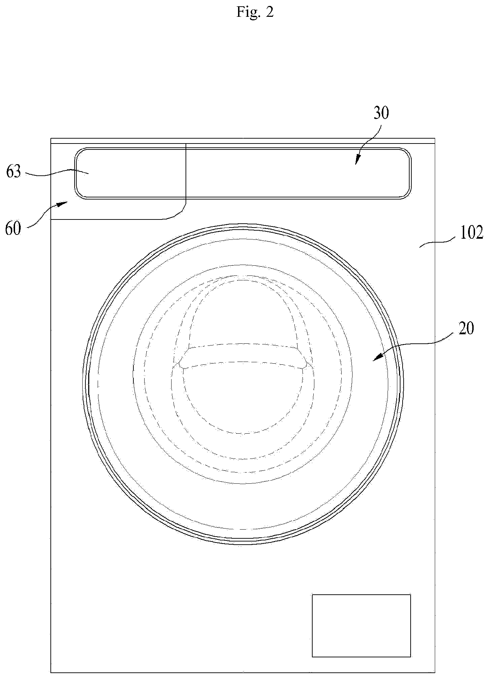

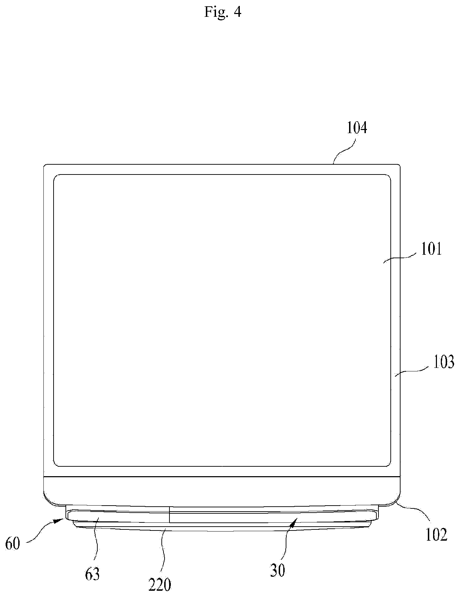

A laundry treating apparatus 1 in accordance with a first preferred embodiment of the present invention will be described, with reference to FIGS. 1 to 5.

The laundry treating apparatus 1 in accordance with a first preferred embodiment of the present invention includes a cabinet 10 which forms an exterior appearance thereof. And, the laundry treating apparatus 1 includes a control panel 30 for receiving control information from a user.

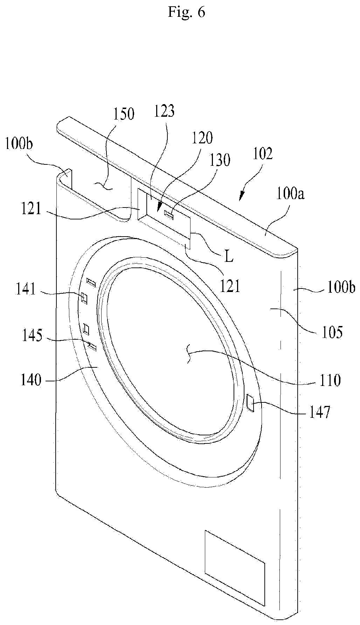

The laundry treating apparatus 1 has a laundry opening 110 (See FIG. 6) formed in the cabinet 10. The laundry opening 110 may be formed in a front side of the cabinet 10. The laundry treating apparatus 1 includes a door 20 mounted to the cabinet 10 for opening/closing the laundry opening 110.

The cabinet 10 has a laundry holding space provided therein. The cabinet 10 may have a rotatable drum 40 provided therein. In this case, the laundry may be held in the drum 40. The present invention does not exclude a cabinet type dryer. In this case, the laundry treating apparatus 1 may not have the drum 40 provided thereto.

The cabinet 10 may include a front cover 102 arranged on the front side of the laundry treating apparatus 1. And, the cabinet 10 may include a rear cover 104 positioned opposite to the front cover 102. The cabinet 10 may include a top plate 101 provided to top edges of the front cover 102 and the rear cover 104, and a base (not shown) provided to a bottom side. And, the cabinet 10 may further include side covers 103 between the front cover 102 and the rear cover 104. As the front cover 102, the rear cover 104, the top plate 101 and the side covers 103 are coupled together, a space is formed for holding the laundry and housing elements of the laundry treating apparatus 1 therein.

The front cover 102 may construe a front side of the cabinet 10, and the front cover 102 may have the laundry opening 110 formed therein for introduction of the laundry (See FIG. 6). The laundry opening 110 may be an opening, for introduction of the laundry to the drum 40, or taking out the laundry from the drum 40 through the laundry opening 110.

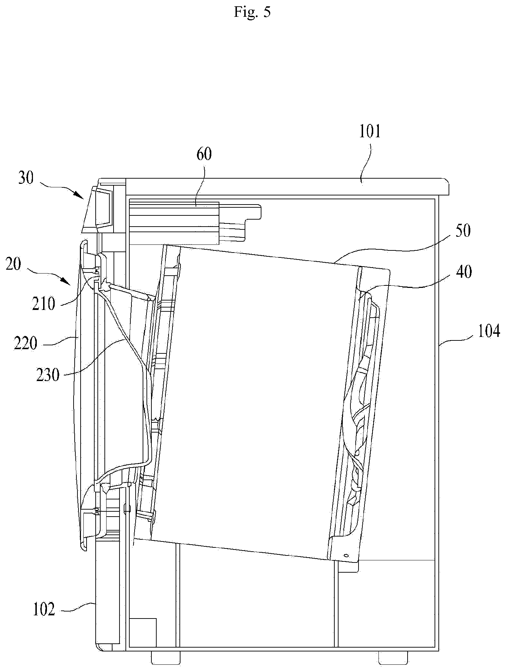

Referring to FIG. 5, the cabinet 10 may have the drum 40 provided therein. The drum 40 is rotatably provided, for holding the laundry therein. The user may introduce the laundry intended to treat to an inside of the drum 40. If the laundry treating apparatus is a washing machine which removes contaminant from the laundry by using washing water, the laundry treating apparatus may further include a tub 50. The tub 50 is provided to an outside of the drum 40 for holding the washing water.

On the front side of the cabinet 10, i.e., the front cover 102 may have a detergent supply unit 60 provided thereto for holding detergent therein. Along with this, the detergent supply unit 60 may be provided in a drawer panel type, and may be provided with a drawer hand grip 63 for assisting pushing in/pulling out of the detergent supply unit 60.

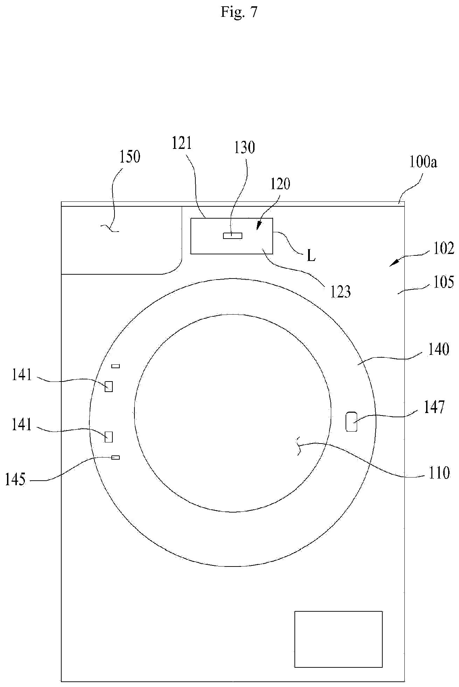

The front cover 102 of the laundry treating apparatus in accordance with a first preferred embodiment of the present invention will be described in detail, with reference to FIGS. 6 and 7.

The front cover 102 may construe the front side of the cabinet 10, and is provided to a front side of the laundry treating apparatus. The front cover 102 may include a front plate 105. The front cover 102 may further include a top flange 100a extended from a top edge of the front plate 105 toward an inside of the cabinet 10. The front cover 102 may further include side flanges 100b extended from both side edges of the front plate 105 toward the inside of the cabinet 10. The front cover 102 may further include a lower flange (Not shown) extended from a lower edge of the front plate 105 toward the inside of the cabinet 10.

In this specification, the front side of the front cover 102 may mean the front plate 105, or a front side of the front plate 105.

The control panel 30 is arranged at the cabinet 10. One of the front side of the front cover 102 or the rear side of the control panel 30 may have a projected portion 320 provided thereto, and the other one may have a recess 120 provided thereto for inserting and housing the projected portion 320 therein.

If the projected portion 320 is provided to the front cover 102, the rear side of the control panel 30 may have the recess 120 provided thereto for inserting the projected portion 320 of the front cover 102 therein. Opposite to this, if the projected portion 320 is provided to the rear side of the control panel 30, the recess 120 may be provided in the front cover 102 for inserting the projected portion 320 of the control panel 30 therein.

Hereinafter, a case will be described as an example, in which the projected portion 320 is formed on the rear side of the control panel 30, and the recess 120 is formed in the front cover 102. However, an example in which positions of the projected portion 320 and the recess 120 are interchanged will not be excluded. Since it is apparent to persons skilled in this field of art, the example of interchange of the mounting positions of the projected portion 320 and the recess 120 will not be described, separately.

The front cover 102 has the recess 120 provided thereto for coupling to the control panel 30. The recess 120 may be provided to the front plate 105, and the projected portion 320 provided to the rear side of the control panel 30 may be inserted in the recess 120.

The recess 120 may include a flange 121 extended from the front side of the front plate 105 toward the inside of the cabinet 10 along a closed loop L. The recess 120 may further include a closing portion 123 extended from the flange 121 to close the inside space of the loop L.

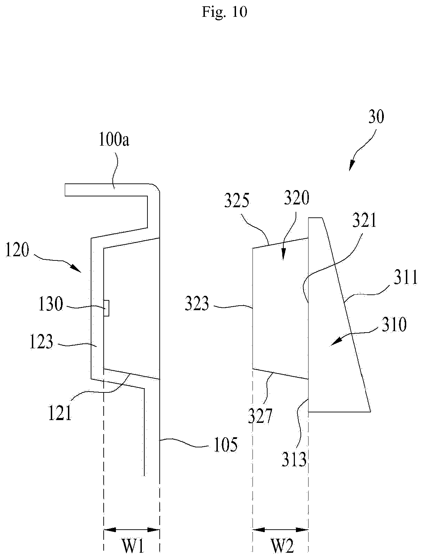

The recess 120 may have a predetermined width W1 (See FIG. 10) by the flange 121. The recess 120 may have an opened front side, and a closed rear side of the closing portion 123. The projected portion 320 of the control panel 30 may be inserted in the recess 120 through the opened front side of the recess 120.

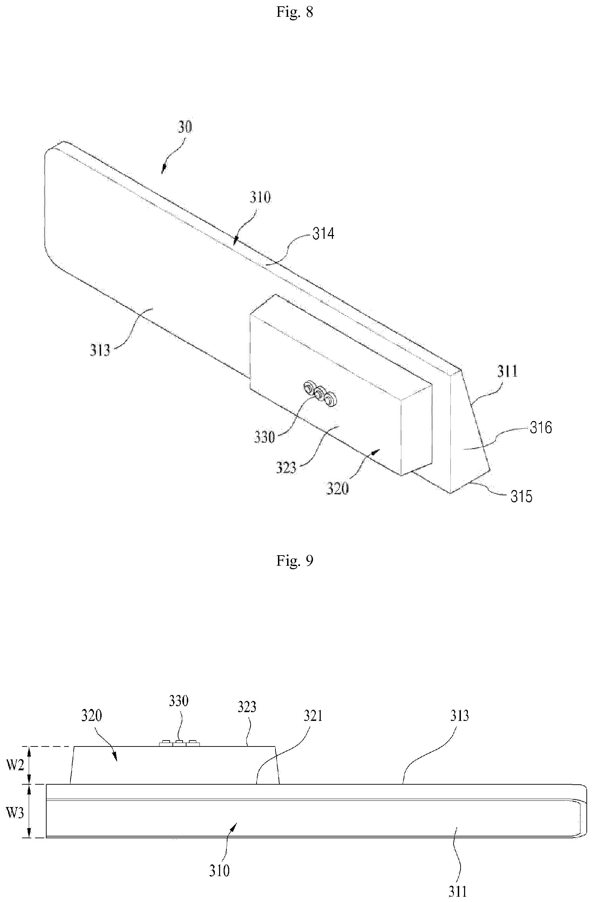

In the meantime, the recess 120 may have a connection terminal 130 provided thereto to be coupled to a jack 330 (See FIG. 8) formed on the projected portion 320 of the control panel 30, electrically. The connection terminal 130 may be provided to the closing portion 123 of the recess 120. The connection terminal 130, electrically connected to the jack 330, serves as a window for supplying power to the control panel 30 and exchanging electric signal information with the control panel 30.

It is preferable that the recess 120 is positioned on an upper side of the front plate 105. It is preferable that the recess 120 is positioned at a central portion of the upper side of the front plate 105.

The recess 120 may be positioned spaced a predetermined distance from the top side edge of the front plate 105. Between the top side edge of the recess 120 and the top side edge of the front plate 105, there is a portion of the front side of the front plate 105 provided thereto. A surface positioned between the top side edge of the recess 120 and the top side edge of the front plate 105 may be positioned on the same plane with the front side of the front plate 105 having no recess 120 provided thereto.

In the meantime, the laundry opening 110 may be provided to a central portion of the front plate 105. The laundry opening 110, being an opened space, may be formed circular. The laundry may be introduced to the drum 40 or taken out of the drum 40 through the laundry opening 110.

Provided to an outside of the laundry opening 110, there may be a seating portion 140 provided thereto for seating a door frame of the door 20 thereon. The seating portion 140, a portion on which an inner frame 210 of the door frame is to be seated, is formed recessed toward an inside of the cabinet 10 from the front side of the front plate 105.

Along with this, the seating portion 140 may have hook hole 147 formed therein for coupling with a hook 260 of the door 20. The seating portion 140 may have a hinge inserting hole 141 formed therein for inserting a hinge arm 250 of the door 20 therein. The seating portion 140 may have a bracket coupling recess 145 formed therein for coupling of the bracket 240 of the door 20 thereto. The seating portion 140 and a configuration in which the door 20 is coupled to the seating portion 140 will be described in detail, later.

On one side of the front plate 105, there may be a mounting portion 150 provided thereto for providing the detergent supply unit 60 thereto. The mounting portion 150, being an opened space, may have the detergent supply unit 60 coupled thereto. In the meantime, on a front side of the detergent supply unit 60, there may be a hook hole (Not shown) formed therein for coupling to the drawer hand grip 63, to be described later.

The control panel 30 will be described with reference to FIGS. 8 to 10.

Referring to FIGS. 8 to 10, the control panel 30 includes a control panel body 310 having a predetermined width W3. And, the control panel 30 may include the projected portion 320 provided to a rear side 313 of the control panel body 310. The projected portion 320 may be formed as one unit with the control panel body 310.

The control panel body 310 is an element for receiving washing information from the user or displaying the washing information thereon, may have a front side 311 provided with at least one of an input unit for receiving the washing information and a display (an output unit) for displaying the washing information thereon, and, preferably, provided both with the input unit and the display (the output unit).

The control panel body 310 may include the front side 311 having a predetermined width W3 exposed to an outside thereof. The control panel body 310 may include the rear side 313 facing the front side of the front cover 102. In this case, the control panel body 310 has the front side 311 sloped to face upward. The control panel body 310 further includes an upper side 314, a lower side 315 and two opposite sides 316. The opposite sides having a trapezoidal form with a lower base larger than an upper base.

The laundry treating apparatus may be installed at a position lower than eyes of the user. In this case, the control panel 30 may be positioned at a position lower than the eyes of the user. In order to enhance visibility of the input unit and the display on the control panel 30, it is preferable that the front side 311 of the control panel body 310 is sloped in a direction of the user's eyes.

Therefore, if the rear side 313 of the control panel body 310 is vertical, a side of the control panel body 310 may have a trapezoidal shape.

The rear side 313 of the control panel body 310 may have the projected portion 320 provided thereto. The projected portion 320 may be projected from the rear side 313 of the control panel body 310 toward an inside of the cabinet 10. The projected portion 320 may be inserted in the recess 120 formed in the front plate 105 for making the control panel 30 to be coupled, and fixedly secured, to the front plate 105.

The projected portion 320 may have a predetermined width W2, and may include a front side 321 and a rear side 323. The front side 321 of the projected portion 320 may couple to the rear side 313 of the control panel body 310, and the rear side 323 of the projected portion 320 may seat on the closing portion 123 of the recess 120.

Provided to the rear side 323 of the projected portion 320, there may be the jack 330 to be coupled to the connection terminal 130 of the recess 120 electrically. Provided to an inside of the projected portion 320, there may be at least one of a microcomputer and a power source unit of the control panel 30, and preferably, electric elements for driving the control panel 30.

It is preferable that the projected portion 320 has a cross sectional area smaller than the rear side 313 of the control panel body 310. It is preferable that the rear side 323 of the projected portion 320 coupled to the rear side 313 of the control panel body 310 has an area smaller than an area of the rear side 313 of the control panel body 310.

The projected portion 320 may be inserted in the recess 120 formed in the front plate 105.

The control panel body 310 is projected forward from a front side of the front plate 105. The control panel body 310 may be mounted projected from the front side of the front plate 105. The front side 311 of the control panel body 310 may be sloped to face upward.

The control panel body 310 may have a rectangular shape having ratios of short sides to long sides are not the same. That is, the control panel body 310 may have a rectangular bar shape. The control panel body 310 may have the long side extended in a transverse direction of the front cover 102.

If the control panel body 310 has the rectangular shape, an area of the projected portion 320 may occupy 1/2 to 1/10 of an area of the rear side 313 of the control panel body 310. Preferably, the area of the projected portion 320 may be 1/2 to 1/3 of the area of the rear side 313 of the control panel body 310.

The projected portion 320 may be provided to deviate to one of a left side and a right side of the rear side 313 of the control panel body 310. The projected portion 320 may be provided to deviate to one of the left side or the right side in a length direction of the rear side 313 of the control panel body 310.

The recess 120 may be positioned at the central portion of the upper side of the front plate 105. If the projected portion 320 is positioned at a central portion of the rear side 313 of the control panel body 310, the control panel body 310 may interfere with the mounting portion 150.

Therefore, it is preferable that the projected portion 320 is provided deviated to one side from the central portion of the control panel body 310. It is preferable that the projected portion 320 is provided deviated in a direction the mounting portion 150 is positioned.

Referring to FIG. 10, coupling of the control panel 30 to the front cover 102 will be described in detail.

The projected portion 320 of the control panel 30 may be inserted in the recess 120 formed in the front plate 105. It is preferable that the recess 120 has a shape in conformity with an outside shape of the projected portion 320.

The projected portion 320 is inserted in the recess 120 through an opened front side of the recess 120. In this case, the closing portion 123 of the recess 120 and the rear side 323 of the projected portion 320 are coupled closely. In this case, the connection terminal 130 provided to the closing portion 123 and the jack 330 provided to the rear side 323 of the projected portion 320 may be coupled, electrically.

The projected portion 320 may have an upper side 325, a lower side 327, and sides coupled to the flange 121 of the recess 120 to be in contact thereto. If the projected portion 320 is inserted in the recess 120, the flange 121 and the upper side 325, the lower side 327, and the sides may couple to be in close contact with each other.

At least one of the upper side 325, the lower side 327, and the sides of the projected portion 320 may be provided sloped toward the central portion of the projected portion 320. Since the flange 121 and the closing portion 123 of the recess 120 are in conformity with the outside shape of the projected portion 320, the flange 121 may be formed sloped outward from the central portion of the recess 120. By forming the sides of the projected portion 320 and the recess 120 to have slopes, alignment of the projected portion 320 with the recess 120 may be easy when the projected portion 320 is inserted in the recess 120.

The front side 321 of the projected portion 320 may be projected to an outside of the front plate 105. The width W2 of the projected portion 320 may be formed larger than the width W1 of the recess 120. However, it is preferable that the width W2 of the projected portion 320 is the same with the width W1 of the recess 120. In this case, the width W1 of the recess 120 means a depth of a space the recess 120 forms. That is, the width W1 does not include a thickness of the closing portion 123. Therefore, the front side 321 of the projected portion 320 may be positioned on the same plane with the front side of the front plate 105.

Since the projected portion 320 is provided to be projected from the rear side 313 of the control panel body 310, if the projected portion 320 is inserted in, and coupled to, the recess 120, the control panel body 310 may be projected to an outside of the front plate 105. In other words, the control panel body 310 may be provided to be projected forward from the front cover 102 (The front plate 105).

In this case, the forward may mean an outside direction of the cabinet 10, and if the projected portion 320 is inserted in the recess 120, the projected portion 320 is coupled to the recess 120 such that the rear side 313 of the control panel body 310 abuts the front side of the front plate 105. And, an upper side, a lower side and the front side 311 of the control panel body 310 are projected to an outside of the front plate 105. Along with this, the rear side 313 of the control panel body 310 may be in close contact with the front side of the front plate 105.

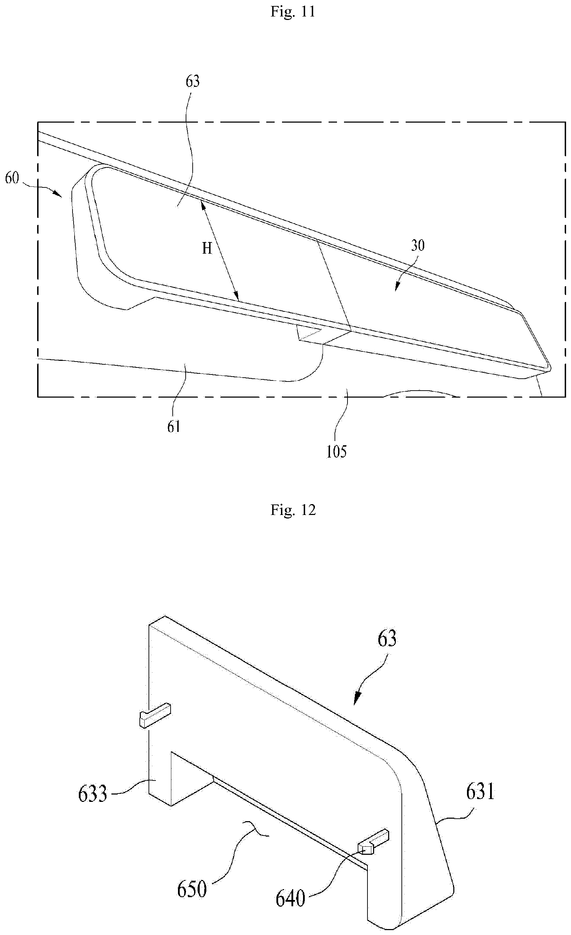

Referring to FIGS. 11 to 13, the detergent supply unit 60 includes a drawer panel 61 which enables the detergent supply unit 60 to be pushed in/pulled out of the cabinet 10. And, the detergent supply unit 60 may include a drawer hand grip 63 provided to the front side of the drawer panel 61 for the user's hand to hold thereon for pushing in/pulling out the drawer panel 61.

The drawer panel 61 may have a space for holding the detergent therein. If the drawer panel 61 is pushed in the cabinet 10, the front side of the drawer panel 61 is positioned on the same plane with the front side of the front cover 102.

The drawer hand grip 63 is provided to the front side of the drawer panel 61. The user may hold the drawer hand grip 63 and push or pull the drawer panel 61 in/out of the cabinet 10.

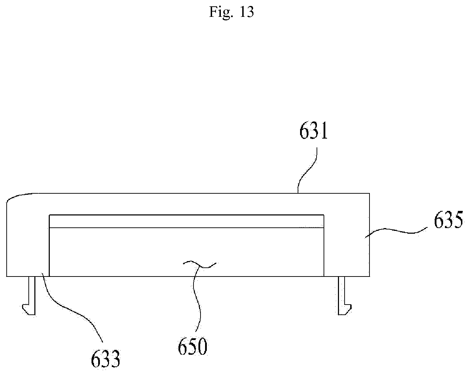

Referring to FIGS. 12 and 13, the drawer hand grip 63 has an underside 635 and a rear side 633 with a cut-away portion 650 formed recessed in portions thereof.

The cut-away portion 650 is not formed in the front side of the drawer hand grip 63, and the user may put a hand therein to hold the drawer hand grip 63. That is, if the user puts in user's fingers in the cut-away portion 650 and pushes or pulls the front side 631 of the drawer hand grip 63, the drawer panel 61 may be pushed in or pulled out.

The drawer hand grip 63 may be formed to have the same shape with the control panel body 310. That is, if provided to the front side of the drawer panel 61, the drawer hand grip 63 may be fabricated to give a sense of unity with the control panel body 310.

The drawer hand grip 63 has a width the same with the width W3 of the control panel body 310, and a height H of the front side 631 thereof the same with the height 311 of the control panel body 310.

Along with this, the front side 631 of the drawer hand grip 63 may be formed sloped to face upward the same with the front side 311 of the control panel body 310. Therefore, if the drawer panel 61 is pushed in, the front side 631 of the drawer hand grip 63 may be positioned on the same plane with the front side 311 of the control panel body 310.

The rear side 633 of the drawer hand grip 63 may have a coupling member 640 provided thereto for coupling the drawer hand grip 63 to the drawer panel 61.

The coupling member 640 may be a hook having a holding step. The hook 640 may be inserted in a hook hole (Not shown) formed in the front side of the drawer panel 61 to couple the drawer hand grip 63 to the drawer panel 61.

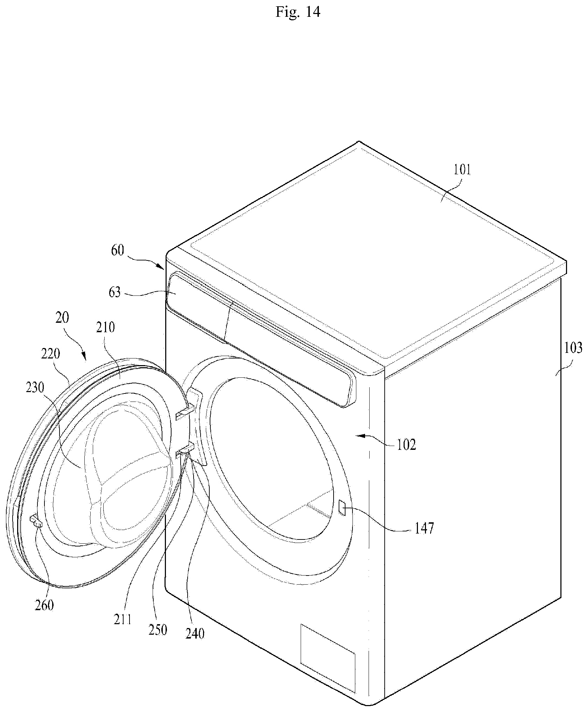

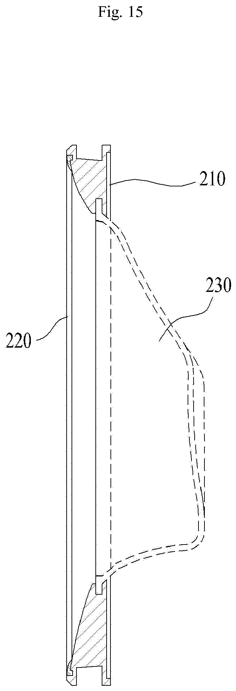

The door 20 will be described in detail with reference to FIGS. 14 and 15.

Referring to FIGS. 14 and 15, the door 20 may include the inner frame 210 seated on the seating portion 140 formed on the front cover 102. And, the door 20 includes an outer frame 220 coupled to the inner frame 210. The door 20 may further include a door glass 230 coupled between the inner frame 210 and the outer frame 220.

The inner frame 210 and the outer frame 220 may be detachably coupled and separably provided.

The inner frame 210 is fabricated in a shape in conformity with a shape of the seating portion 140. The seating portion 140 may be formed circular, and the inner frame 210 may also be formed circular. The inner frame 210 may be provided in an annular shape for providing the door glass 230 on an inside of the inner frame 210.

The outer frame 220 is coupled to an outside of the inner frame 210, and is provided to be projected to an outside of the cabinet 10. The outer frame 220 may be provided to have an inside in close contact with the front side of the front cover 102, or positioned in an outside direction of the cabinet 10 by a predetermined distance from the front side of the front cover 102. There may be the door glass 230 coupled between the inside of the outer frame 220 and the inner frame 210.

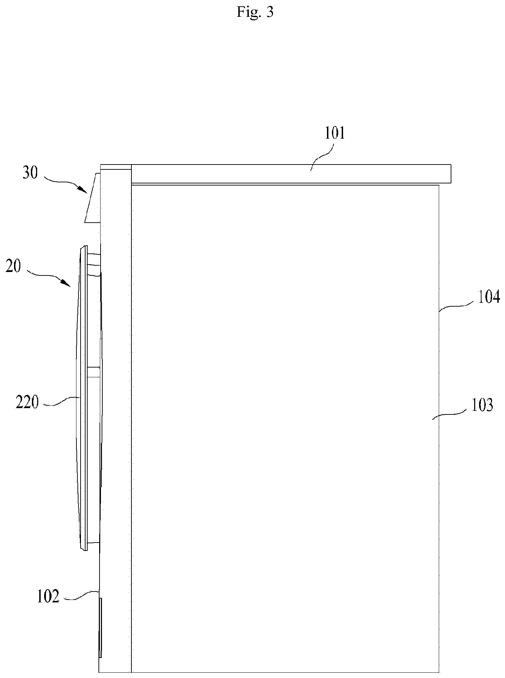

Referring to FIG. 3, the outer frame 220 is provided to be projected to an outside of the front cover 102, and the outer frame 220 is provided to be projected to the outside direction of the cabinet 10 when the door 20 is closed.

The seating portion 140 is recessed to an inside of the cabinet 10 for receiving the inner frame 210. Opposite to this, the outer frame 220 is coupled to be projected to the outside direction of the cabinet 10. It may be said that the outer frame 220 is coupled projected from the front side of the front cover 102 to the outside direction of the cabinet 10. Though the outer frame 220 may have a portion with a predetermined width received in the seating portion 140, it is preferable that the outer frame 220 may be coupled without being received in the seating portion 140 such that the whole outer frame 220 is projected to the outside direction of the cabinet 10.

Referring to FIG. 14, the door 20 include a bracket 240 coupled to the seating portion 140. And, the door 20 may include a hinge arm 250 projected forward from the bracket 240. The bracket 240 is fastened to a bracket coupling recess 145 (See FIG. 7) formed in the seating portion 140. The hinge arm 250 may be extended to an inside of the cabinet 10 passed through the hinge arm inserting hole 141 formed in the seating portion 140.

The hinge arm 250 has one end provided between the inner frame 210 and the outer frame 220.

The one end of the hinge arm 250 may have a hinge shaft (Not shown) provided thereto, and the hinge shaft is rotatably coupled between the inner frame 210 and the outer frame 220.

The inner frame 210 may have a hinge arm inserting hole 211 formed therein for pass through of the hinge arm 250.

The inner frame 210 may have one side provided with a hook 260, and the hook 260 may be coupled to a hook hole 147 formed in the seating portion 140. The hook 260 may be coupled to a locking switch provided to the hook hole 147.

Since the outer frame 220 is detachably provided to the inner frame 210 and projected from the front side of the front cover 102, the outer frame 220 may be fabricated in a variety of shapes regardless of shapes of the seating portion 140 and the inner frame 210.

Referring to FIG. 14, the outer frame 220 may be formed circular identical to the inner frame 210.

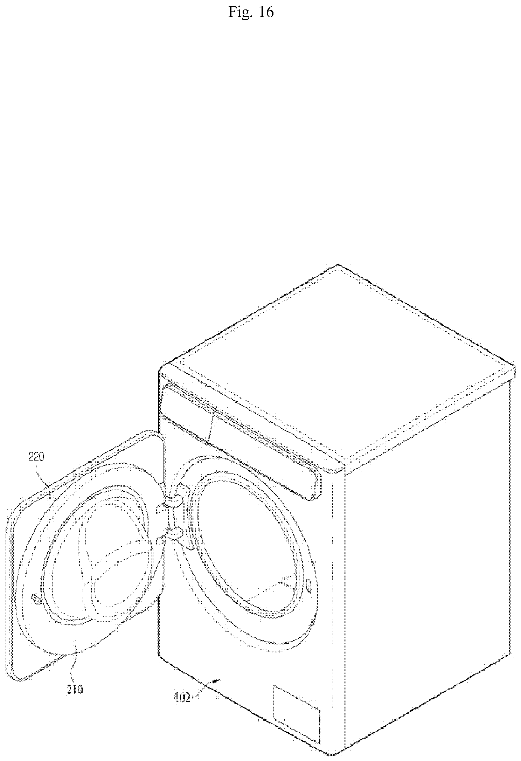

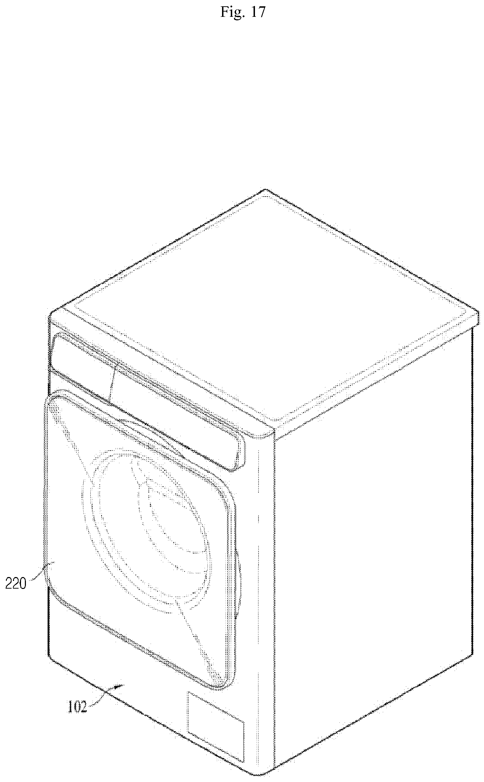

Referring to FIGS. 16 and 17, the outer frame 220 may be formed in a square shape. As described before, since the outer frame 220 is provided projected to the outside from the front side of the front cover 102, the outer frame 220 may be fabricated not in conformity with the shape of the inner frame 210 and the seating portion 140. Accordingly, degrees of freedom of fabrication of the outer frame 220 may be enhanced.

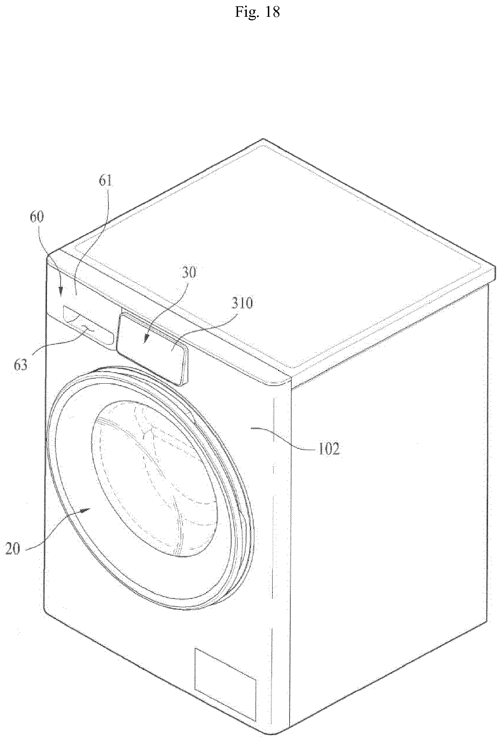

In the meantime, referring to FIG. 18, since the control panel body 310 of the control panel 30 may be formed to have a short length, and, since the control panel body 310 is provided to be projected from the front side of the front cover 102, the control panel body 310 may be fabricated in a variety of shapes and sizes within a range the shapes and the sizes do not interfere with the door 20 or the detergent supply portion 60. As shown in FIG. 18, if the control panel body 310 has a relatively small aspect ratio, the hand grip may be formed in the drawer panel 61 of the detergent supply unit 60 in the shape of the recess 63.

According to demands of users, the laundry treating apparatus has a variety of shapes of products with price ranges different from one another launched. In order to fabricate the variety of products, it is required to provide production lines fit to the variety of products.

However, if individual production lines are provided for each of the products, there are disadvantages in that a large space is required for installation of equipment for the production lines meeting each of the products, and a high production cost is required due to difference of the equipment for the production lines.

As has been described, the present invention has an advantage of enhancing the degrees of freedom of fabrication of the control panel by projecting the control panel body 310 to the outside of the front cover. That is, the present invention has an advantage of applying the same front cover to laundry treating apparatuses of different price ranges.

In detail, by applying a front cover having the same standard of the recess to all products and making a size of the control panel to be coupled to the recess different, the products may become different. By standardizing the front cover and the recess formed therein for application to the variety of production lines, one front cover may be applicable to the variety of production lines. In this case, since functions and configurations of the products are different from one another, sizes and functions for controlling the products may be different, too.

In this case, the present invention standardizes the projected portion to be inserted in the recess, and makes the body to be coupled to the projected portion projected to the outside of the front cover, for enabling to enhance the degrees of freedom of the body. That is, the control panel having the input unit and the display provided thereto may be fabricated in a variety of shapes according to the products, and by fabricating the control panel bodies fit to the variety of product groups and coupling the control panel bodies fabricated thus to the standardized front covers, the same front cover may be used regardless of the variation of the sizes and the shapes of the control panel.

Eventually, since the individual production lines of the front cover are not required for the variety of product groups, the production cost can be saved, and the space required for the equipment of the production lines can be reduced, at the end.

And, by projecting the outer frame of the door to the outside of the front cover, degrees of freedom of fabrication, and shapes, of the door can be enhanced.

Since the user's aesthetics on the products are different according to the shapes of the outer frame exposed to an outside, the users may recognize the variety of products different from one another.

In this case, as described before, if the shapes of the front covers are varied with the shapes of the outer frames, it is required to construct the variety of production lines. However, the present invention has an advantage of enabling to change the shape of the outer frame regardless of the shape of the front cover by coupling the outer frame projected to the outside of the front cover.

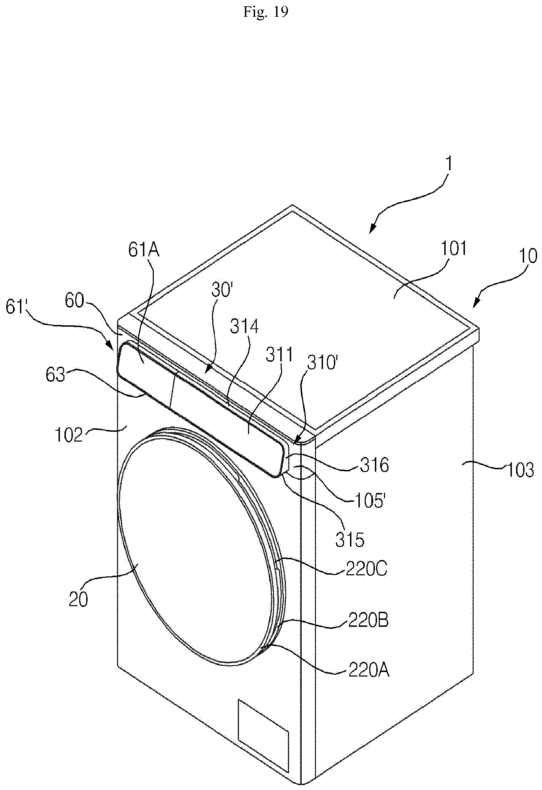

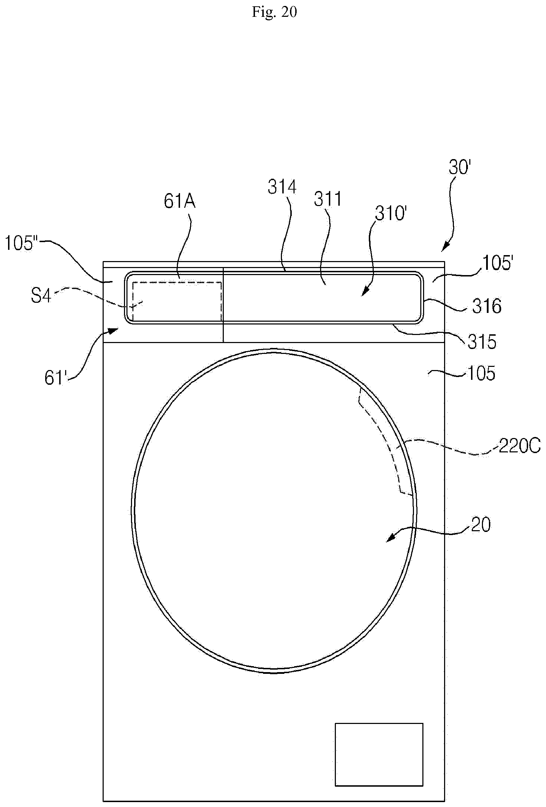

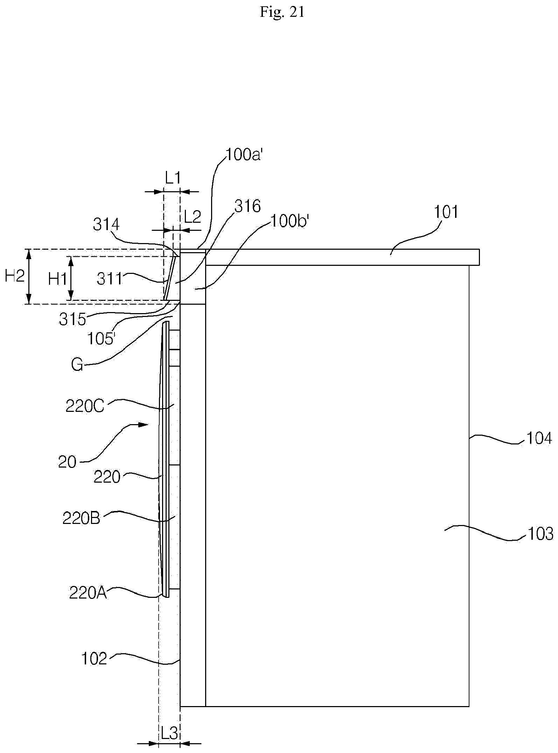

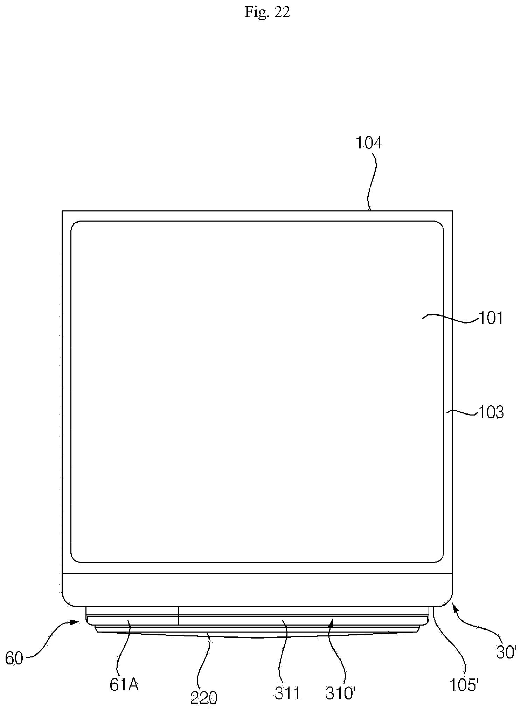

A laundry treating apparatus in accordance with a second preferred embodiment of the present invention will be described with reference to FIGS. 19 to 24.

In the embodiment, a control panel 30' may include a control panel body 310' and a PCB assembly 400.

The control panel 30' may include a front plate 105'. The front plate 105' of the control panel 30' may form an exterior appearance of a portion of a front side of the laundry treating apparatus. The front plate 105' of the control panel 30' may be positioned on an upper side of the front plate 105 of the front cover 102 described in the first preferred embodiment of the present invention.

The control panel 30' may include an upper flange 100a' formed on the front plate 105'. The control panel 30' may further include a side flange 100b' formed on a side of the front plate 105'. The control panel 30' may have one pair of the side flanges 100b' formed opposite to each other. The control panel 30' may further include a lower flange 100c' formed on a lower side of the front plate 105'. The control panel 30' may be mounted to be positioned on an upper side of the front plate 105 of the front cover 102.

The control panel 30' may have a rear space S1 formed among the front plate 105', the upper flange 100a', the side flange 100b' and the lower flange 100c' for housing at least a portion of the PCB assembly 400.

The control panel 30' may have a mounting portion 150' formed therein for mounting a drawer panel 61' thereon. The mounting portion 150' may be positioned on a side of the side flange 100b'. The mounting portion 150' may be formed as one unit with the side flange 100b'.

The PCB assembly 400 may include a PCB 402 provided with an operation unit and a display. The PCB assembly 400 may further include a PCB cover 404 having a PCB 402 mounted thereto. The PCB assembly 400 may have the PCB 404 mounted to at least one of the front plate 105', the side flange 100b', the upper flange 100a', and the lower flange 100c' with a fastening member, such as a screw.

The PCB 402 may have at least one display, and at least one switch mounted thereto. The display, for displaying information on the laundry treating apparatus, may include various electric components, such as LED or LCD. The switch, for operating the laundry treating apparatus, may include various electric components, such as a push button switch or a touch switch.

The PCB assembly 400 may further include a light guide (Not shown) for guiding a light of the display, and the light guide may be mounted to the PCB 402. The light guide may be mounted to face the window 350 to be described, later.

The control panel body 310' includes a display 350 positioned on the upper side of the cabinet 10 in front of the front side of the cabinet 10 to have a front side 311 sloped to face upward. The control panel body 310' may be arranged to be projected forward from the front plate 105'. The front side 311 of the control panel body 310' is sloped to face upward. The control panel body 310' may further include an upper side 314, a lower side 315 and two opposite sides 316 exposed to an outside of the laundry treating apparatus. The control panel body 310' may have a front/rear direction width L1 of the lower side 315 larger than a front/rear direction width L2 of the upper side 314. The control panel body 310' may have an up/down direction width H1 thereof smaller than an up/down direction width H2 of the front side of the front plate 105'. In this case, the up/down direction width H1 of the control panel body 310' may be a height of the control panel body 310'.

That is, the control panel body 310' may have a shape projected forward from the front plate 105' three dimensionally, and the front side 311 of the control panel body 310' may be positioned sloped to face upward by a predetermined angle at a front most position of a portion arranged to be projected forward from the front plate 105'.

If the control panel body 310' is not projected forward from the front plate 105', but if the front side 311 of the control panel body 310' is positioned at a vertical plane the same with the front side of the front plate 105', the front side 311 of the control panel body 310' may face only a forward direction of the laundry treating apparatus in a front/rear direction of the laundry treating apparatus. In this case, a whole front side of the control panel body 310' may be poorly visible from an upper side of the front of the laundry treating apparatus, and even handling of the control panel body 310' may not be easy.

However, if the control panel body 310' is projected forward from the front plate 105', and the front side 311 of the control panel body 310' projected thus is sloped by a predetermined angle to face an upper side of the front of the laundry treating apparatus, when the user looks at the front side 311 of the control panel body 310' from the upper side of the front of the laundry treating apparatus, the user can look at the whole front side 311 of the control panel body 310' in a slope direction well, and can input an operation order on the laundry treating apparatus through the front side 311 of the control panel body 310', conveniently.

In the meantime, if the control panel body 310' is, not formed projected forward from the front plate 105', but formed in a shape in which a portion of the upper side of the control panel 30' is recessed sloped by a predetermined angle, as described before, the recessed portion of the control panel 30' may be visible from the upper side of the front of the laundry treating apparatus well, and the operation thereof may be convenient. However, a sloped structure of the portion of the upper side of the control panel 30' is liable to reduce an inside space of the laundry treating apparatus, making utilization of the inside space of the laundry treating apparatus poor.

That is, if the control panel body 310' is projected forward from the front plate 105' as well as the front side 311 of the control panel body 310' is sloped by the predetermined angle to face the upper side of the front of the laundry treating apparatus, the utilization of the inside space of the laundry treating apparatus may be enhanced, as well as the front side 311 of the control panel body 310' is visible well, and the operation order on the laundry treating apparatus may be inputted easily through the front side 311 of the control panel body 310'.

Alike the first embodiment of the present invention, the door 20 has the outer frame 220 which forms an exterior appearance thereof, and, when the door 20 is closed, the outer frame 220 at least a portion thereof is positioned to be projected to the outside of the cabinet 10. The door 20 may have a configuration and operation identical to the first preferred embodiment of the present invention, and detailed description of the configuration and the operation identical to the first preferred embodiment of the present invention will be omitted.

The door 20, the drawer panel 61' and the display 350 are projected forward from the cabinet 10. The door 20 may have the same projected width with the display unit 350, substantially.

The door 20 has a portion facing the lower side 315 of the control panel body 310' in a vertical direction. Formed between the door 20 and the control panel body 310', there is a gap G smaller than the height H1 of the control panel body 310'. The gap G between the door 20 and the control panel body 310' may be an empty space for the user to hold the outer frame 220 projected to the outside of the cabinet 10 with one hand. The user may hold the door 20 easily with means other than the hand grip.

In the meantime, it is preferable that the gap G between the door 20 and the control panel body 310' has a smallest height for the user's finger to be inserted, and it is also preferable that the gap G between the door 20 and the control panel body 310' has a largest height that can make the door 20 and the control panel body 310' to provide a sense of unity on the whole.

If the that the gap G between the door 20 and the control panel body 310' is lower than the height H1 of the control panel body 310', according to the present invention, the door 20 and the control panel body 310' can provide the sense of unity on the whole together with the front cover 102.

The outer frame 220 has a hand grip 220C formed at an outside circumference 220B thereof. The hand grip includes a recess formed at an outside circumferential surface thereof.

The hand grip 220C is formed at the outer frame 220 to face the lower side 315 of the control panel body 310' in the vertical direction.

When closed, the door 20 has at least a portion projected forward of the front plate 105 of the front cover 102, and a largest projection width L3 in a front/rear direction of the door 20 may be the same with the largest front/rear direction projection width L2 of the control panel body 310' substantially, or larger than the largest front/rear direction projection width L2 of the control panel body 310'. In this case, the largest front/rear direction projection width L2 of the control panel body 310' may be the same with the front/rear direction width of the lower side 315 of the control panel body 310'.

The drawer panel 61' is arranged at the control panel 30'. The drawer panel 61' may have a configuration and operation identical to the first embodiment of the present invention, and detailed description of the configuration and operation identical to the first embodiment of the present invention will be omitted.

The drawer panel 61' has a sloped surface 61A positioned on the same plane with the front side 311 of the control panel body 310', substantially. The drawer panel 61' has the sloped surface 61A positioned on the same plane with the front side 311 of the display 350. The sloped surface 61A may be positioned on a side of the front side 311 of the display 350.

The drawer panel 60' may include a drawer hand grip 63 having the sloped surface 61A. The drawer panel 61' may form a hand grip space S4 having opened lower side in rear of the drawer hand grip 63. The hand grip space S4 formed in the drawer panel 61' may be formed by the cut-away portion 650 the same with the first preferred embodiment of the present invention. When the door 20 is closed, the hand grip space S4 may face a portion of the outside circumferential surface 220B of the door 20.

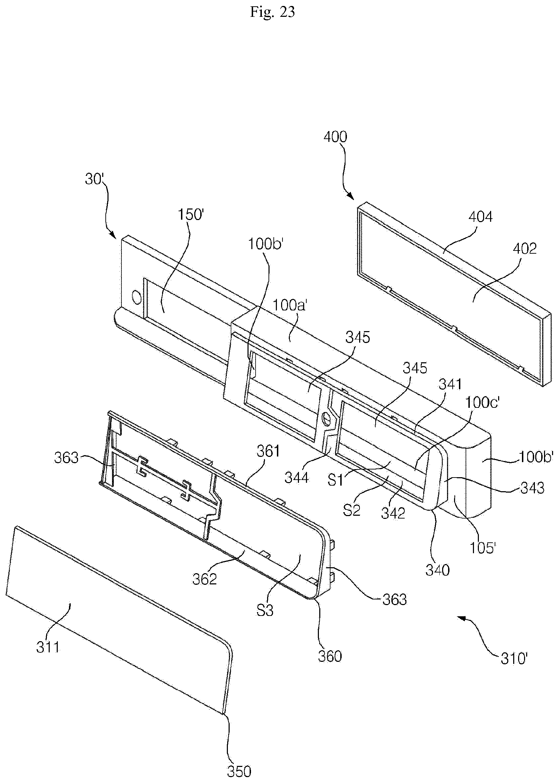

The control panel body 310' will be described with reference to FIG. 23 in more detail.

The control panel body 310' may include a front body portion 340 projected forward from the front plate 105', and a window 350 arranged at the front body portion 340 to have a front side 311 sloped to face upward. The control panel body 310' may further include a deco 360 which surrounds circumferences of the front body portion 340 and the window 350, altogether.

The front body portion 340 may form a space S2 therein. The space S2 formed in the front body portion 340 may be a front space S2 formed in front of the rear space S1, and the front space S2 may have a size smaller than the rear space S1.

The front body portion 340 may include an upper side 341, a lower side 342, and sides 343 which are projected forward from the front plate 105' of the control panel body 310' as one unit thereof. The upper side 341 of the front body portion 340 and the lower side 342 of the front body portion 340 may be formed parallel to each other, and each of which may be extended in a length direction of the control panel body 310'. The lower side 342 of the front body portion 340 may have a front/rear direction width larger than a front/rear direction width of the upper side 341 of the front body portion 340.

The side 343 of the front body portion 340 may be formed to connect the upper side 341 of the front body portion 340 to the lower side 342 of the front body portion 340, and may be projected forward from the front plate 105' as one unit. The front body portion 340 may include one pair of sides 343 facing each other in a lateral direction.

Formed among the upper side 341, the lower side 342 and the sides 343 of the front body portion 340, there may be a front space S2 for inserting at least a portion of the PCB assembly 400 therein. The front space S2 of the front body portion 340 may have a portion of the light guide of the PCB assembly 400 positioned therein.

The front side of the front body portion 340 may further include a front plate 344 sloped to face upward forwardly. The front plate 344 of the front body portion 340 may have a window seating surface for seating the window 350 thereon. The front plate 344 of the front body portion 340 may be formed to be sloped by a predetermined angle to face upward forwardly. If the front body portion 340 includes the front plate 344, the front plate 344 of the front body portion 340 may have an opening 345 for making electric components mounted to the PCB 402, particularly, a portion of the touch switch to be positioned in contact with the window 350.

The laundry treating apparatus may have the front plate 344 sloped at an acute angle from a horizontal plane. The smaller the angle from a horizontal plane, the more the front side 311 of the control panel body 310' sloped to face upward to the maximum, the larger the angle from a horizontal plane, the more the front side 311 of the control panel body 310' sloped to face forward to the maximum.

If the deco 360 is not included, the control panel body 310' may have the upper side, the lower side and the sides of the front body portion 340 exposed to an outside. In this case, the upper side of the front body portion 340 may be the upper side 314 of the control panel body 310', the lower side of the front body portion 340 may be the lower side 315 of the control panel body 310', and the sides of the front body portion 340 may be the sides 316 of the control panel body 310'.

The window 350 may be formed in a plate shape. The window 350 may be the display for displaying information the laundry treating apparatus displays to the outside. The display may be positioned on the upper side of the cabinet 10 in front of the front side of the cabinet 10 with a front side 311 thereof sloped to face upward. A light emitted from the display may be incident on the window 350 for the user to watch the window 350 to notice information on the laundry treating apparatus.

The window 350 may be an operation panel for the user to touch or apply a pressure thereto for operation of the laundry treating apparatus. The window 350 may further include a touch screen. The user may touch or apply the pressure to the window 350, and may handle the switch on the PCB assembly 400. The window 350 may be positioned in front of the front body portion 340. Of course, the window 350 may be fastened to at least one of the front body portion 340, the PCB assembly 400, and the deco 360 with fastening members, such as screws, fastened with hooking means, such as hook or the like, or attached with an adhesive member, such as two-sided tape.

The front side of the window 350 may be the front side 311 of the control panel body 310'.

The deco 360 may include at least one of an upper side 361, a lower side 362, and a side 363. It is possible to arrange the deco 360 to surround the upper side, the lower side, the left side, and the right side of the front body portion 340. The deco 360 may include one pair of opposite sides 363, the upper side 361, the lower side 362, and the one pair of the sides 363 may surround the upper side, the lower side, the left side, and the right side of the front body portion 340, and the upper side 361, the lower side 362, and the one pair of the sides 363 may surround the upper side, the lower side, the left side, and the right side of the window 350.

The deco 360 may have a space S3 formed among the upper side 361, the lower side 362, and the sides 363. The deco 360 may have a hook portion for holding the window 350 for preventing the window 350 from falling off the deco 360 in a front direction of the deco 360. The hook portion may be projected from the deco 360 toward a space S3. The deco 360 may function as a window holder for securing the window 350. It is preferable that the deco 360 includes all of the upper side 361, the lower side 362, and the sides 363. The deco 360 may have a metal layer coated to an outside surface thereof. The deco 360 may have the outside surface coated with chromium for improving ornamental beauty of the laundry treating apparatus.

If the deco 360 surrounds the upper side, the lower side, the left side, and the right side of the front body portion 340, the upper side of the deco 360 may be the upper side 314 of the control panel body 310', the lower side of the deco 360 may be the lower side 315 of the control panel body 310', and the sides of the deco 360 may be the sides 316 of the control panel body 310'.

The PCB assembly 400 may have at least a portion thereof placed in the space S2 of the front body portion 340. The PCB assembly 400 may be mounted to position the light guide between the PCB 402 and the window 350, at least a portion of the light guide may be positioned between the front space S2 of the front body portion 340, and at least a portion of the PCB cover 404 may be positioned in the rear space S1.

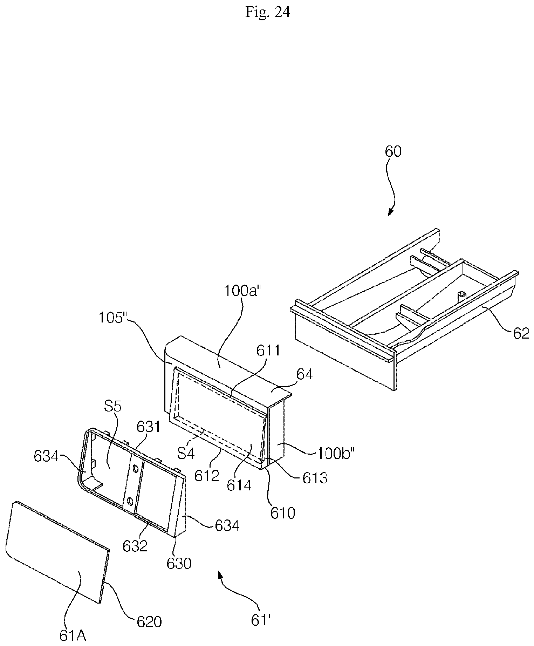

The drawer panel 61' will be described in more detail with reference to FIG. 24.

The drawer panel 61' may include the detergent box 62 for holding detergent. The drawer panel 61' may include an outer body 64 exposed to an outside.

The detergent box 62 may have a detergent holding space formed therein for holding the detergent. The detergent box 62 may be formed as one unit with the outer body 64, or may be fastened to the outer body 64 with a fastening member, such as a screw.

The outer body 64 may include a front plate 105". The front plate 105" of the outer body 64 may form an exterior appearance of a portion of the front side of the laundry treating apparatus. The outer body 64 may include an upper flange 100a" formed on an upper side of the front plate 105". The outer body 64 may further include side flanges 100b" formed at sides of the front plate 105". The outer body 64 may have one pair of the side flanges 100b" formed to face each other. The control panel 30' may be mounted to be positioned on an upper side of the front plate 105 of the front cover 102.

The drawer panel 61' may include a drawer body portion 610 projected forward, and a drawer cover 620 having a sloped side 61A arranged at the drawer body portion 610 to be positioned on a plane the same with the front side 311 of the control panel body 310', substantially. The drawer panel 61' may further include a drawer deco 630 which surrounds an upper side, a left side, a right side, and a circumference of the drawer cover 620, altogether.

The drawer body portion 610 may be projected forward from the front plate 105" of the drawer panel 61'. The outer body 64 may have a hand grip identical to the hand grip in accordance with the first embodiment of the present invention formed thereon. The drawer body portion 610 may function as a hand grip together with the drawer cover 620. The drawer body portion 610 may be projected from the front plate 105" of the drawer panel 61' three dimensionally.

The drawer body portion 610 may be positioned on a side of the front body portion 340 of the control panel body 310' shown in FIG. 23, and may have a left/right direction width smaller than the front body portion 340 of the control panel body 310'.

The drawer body portion 610 may include an upper side 611, and sides 613 projected forward from the front plate 105" of the drawer panel 61' as one unit therewith. The upper side 611 of the drawer body portion 610 may be extended in a left/right direction on an upper side of the front plate 105".

The side 613 of the drawer body portion 610 may be projected forward from the front plate 105" of the outer body 64 as one unit therewith. The drawer body portion 610 may include one pair of the sides 613 in a left/right direction to face each other.

The drawer body portion 610 may have a front side with a front plate 614 sloped to face upward forwardly. The front plate 614 of the drawer body portion 610 may have a cover seating surface for the drawer cover 620 to be seated thereon. The front plate 614 of the drawer body portion 610 may be formed sloped to face upward at a predetermined angle forwardly. The front plate 614 of the drawer body portion 610 may be sloped at an angle the same with the front plate 344 of the front body portion 340 shown in FIG. 23.

The drawer body portion 610 may have a shape of an opened lower side, and the drawer body portion 610 may have a hand grip space S4 formed among the upper side 611, the sides 613, and the front plate 614.

The drawer cover 620 may be formed in a plate shape. The drawer cover 620 may be positioned forward of the front side of the cabinet 10 on the upper side of the cabinet 10 to have the front side 61A sloped to face upward. The front side 61A of the drawer cover 620 may be a sloped surface. The drawer cover 620 may be arranged in front of the drawer body portion 610. The drawer cover 620 may have a height the same with a height of the window 350, and may be positioned on a side of the window 350 shown in FIG. 23. As the drawer cover 620 is positioned on the side of the window 350 shown in FIG. 23, the drawer cover 620 can provide a sense of unity with the window 350, thereby making the upper side of the laundry treating apparatus to appear luxurious.

Of course, it is possible to fasten the drawer cover 620 to at least one of the drawer body portion 610 and the drawer deco 630 with a fastening member, such as screw, or with hooking means, such as hook, or attached with an adhesive member, such as a two-sided tape.

The front side of the window 350 may be the front side 311 of the control panel body 310'.

The drawer deco 630 may include at least one of an upper side 631, a lower side 632, and a side 634. It is possible that the drawer deco 630 may be arranged to surround the upper side, the left side and the right side of the drawer body portion 610. The drawer deco 630 may include one pair of opposite sides 634, and the upper side 631, the lower side 632 and one pair of the sides 634 may surround the upper side, the left side and the right side of the drawer body portion 610.

The drawer deco 630 may have a space S5 formed among the upper side 631, the lower side 632, and the sides 634. The drawer deco 630 may have a hook portion formed thereon for holding the drawer cover 620 not to fall off in a front direction. The hook portion may be projected from the drawer deco 630 toward the space S5. The drawer deco 630 may function as a cover holder for securing the drawer cover 620 thereto. It is preferable that the drawer deco 630 includes all of the upper side 631, the lower side 632, and the sides 634. The upper side 631, the lower side 632, and the sides 634 of the drawer deco 630 may surround the circumference of the drawer cover 620.

The drawer deco 630 may have a metal layer coated to an outside surface thereof. The drawer deco 630 may have chromium coated to the outside surface, which can improve ornamental beauty of the laundry treating apparatus.

In the meantime, the PCB assembly 400 may have at least a portion thereof inserted in the space S2 of the front body portion 340. The PCB assembly 400 may have the light guide mounted to be positioned between the PCB 402 and the window 350, at least a portion of the light guide may be positioned in the front space S2 of the front body portion 340, and at least a portion of the PCB cover 404 may be positioned in the rear space S1.

The smaller a portion of the PCB assembly 400 positioned in the rear space S1 and the larger a portion of the PCB assembly 400 positioned in the front space S2, the laundry treating apparatus can secure the more empty space in the laundry treating apparatus, and therefore, it is preferable that the portion of the PCB assembly 400 is inserted in the front space S2 of the front body portion 340 as much as possible.

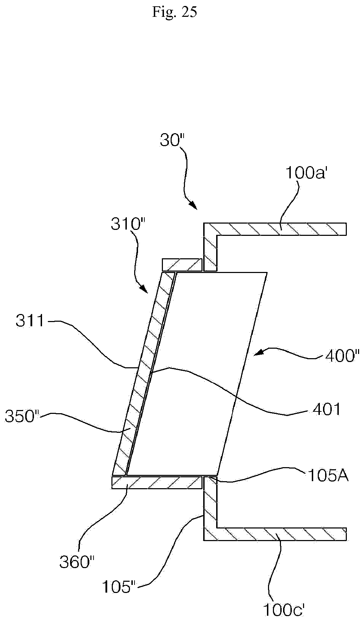

A laundry treating apparatus in accordance with a third preferred embodiment of the present invention will be described in detail with reference to FIG. 25.

Referring to FIG. 25, the laundry treating apparatus may include a PCB assembly 400" having a control panel 30" arranged to pass through an opening 105A formed in the front plate 105". And, the control panel body 310" may include a window 350" arranged at the PCB assembly 400" to have a front side slope to face upward. The control panel body 310" may further include a deco 360" surrounding a circumference of the PCB assembly 400" and a circumference of the window 350", altogether.

Since a configuration and operation of the laundry treating apparatus of the embodiment is identical or similar to the second preferred embodiment of the present invention except the control panel 30", detailed description of the configuration and operation of the laundry treating apparatus of the embodiment will be omitted.

The PCB assembly 400" may have a front portion positioned in front of the opening 105A, and a rear portion positioned in rear of the opening 105A. The PCB assembly 400" may have a front side 401 sloped by a predetermined angle in a direction to face upward forwardly.

Since the PCB assembly 400" may have a configuration and operation identical or similar to the PCB assembly 400 in the second preferred embodiment of the present invention except that the PCB assembly 400" is arranged to pass through the opening 105A formed in the front plate 105", detailed description of the configuration and operation will be omitted.

The window 350" may be arranged in front of the PCB assembly 400" having a front portion projected forward, and, more specifically, in front of the front side 401 of the PCB assembly 400". Since a configuration and operation of the window 350" are identical or similar to the window 350 in the second preferred embodiment of the present invention except that the window 350" is arranged in front of the front side 401 of the PCB assembly 400", detailed description of the configuration and operation will be omitted.

Alike the second preferred embodiment of the present invention, a deco 360" may include all of the upper side 361, the lower side 362, and the sides 363, and the upper side 361, the lower side 362, and the sides 363 may surround a circumference of the PCB assembly 400" and a circumference of the window 350", altogether.

## Claims

1. A laundry treating apparatus (1) comprising:
a cabinet (10) having a laundry opening (110) formed therein;
a control panel (30, 30') arranged at the cabinet (10), the control panel (30, 30') includes a control panel body (310, 310') projected forward from a front plate (105, 105') of the cabinet (10), and the control panel body (310, 310') includes a display (350) positioned on an upper side of the cabinet (10) to have a front side (311) sloped to face upward;
a drawer panel (61, 61') arranged at the control panel (30, 30'), the drawer panel (61, 61') having a sloped side positioned on the same plane with the front side (311) of the control panel body (310, 3 10'); and
a door (20) mounted to the cabinet (10) for opening/closing the laundry opening (110), wherein the door (20) has an outer frame (220) which forms an exterior appearance of the door (20),
**characterized in that**:
the outer frame (220) is positioned such that at least a portion of the outer frame (220) is projected to an outside of the cabinet (10) when the door (20) is closed, and
the door (20) has a portion facing a lower side of the control panel body (310, 310') in a vertical direction and a gap (G) smaller than a height of the control panel body (310, 310', 310") is formed between the door (20) and the control panel body (310, 310'); and
wherein the outer frame (220) comprises a hand grip (220C) formed at an outside circumference (220B) of the outer frame (220), and wherein the hand grip (220C) comprises a recess at the outside circumferential surface thereof, wherein the hand grip (220C) faces the lower side of the control panel body (310, 310') in the vertical direction.

2. The laundry treating apparatus (1) of claim 1, wherein a seating portion (140) is provided to an outside of the laundry opening (110) for seating an inner frame (210) of the door (20) thereon, the seating portion (140) being recessed toward an inside of the cabinet (10) from a front side of thereof.

3. The laundry treating apparatus (1) of claim 2, wherein the inner frame (210) has a shape corresponding to that of the seating portion (140).

4. The laundry treating apparatus (1) of claim 2, wherein the inner frame (210) has a circular shape.

5. The laundry treating apparatus (1) of claim 2, wherein the door (20) comprises a door glass (230) coupled between the inner frame (210) and the outer frame (220).

6. The laundry treating apparatus (1) of claim 2, wherein the inner frame (210) has an annular shape and a door glass (230) is provided on an inside of the inner frame (210).

7. The laundry treating apparatus (1) of any one of the preceding claims, wherein the whole outer frame (220) is exposed to an outside of the cabinet (10).

8. The laundry treating apparatus of any one of the preceding claims, wherein, when the door (20) is closed, the control panel body (310, 310', 310") has a largest projected width in a front/rear direction being substantially equal to a largest projected width in a front/rear direction of the door (20).

## Patentansprüche

1. Wäschebehandlungsvorrichtung (1), die Folgendes umfasst:
ein Gehäuse (10), das eine darin ausgebildete Wäscheöffnung (110) aufweist;
ein Bedienfeld (30, 30'), das am Gehäuse (10) angeordnet ist, wobei das Bedienfeld (30, 30') einen Bedienfeldkörper (310, 310') umfasst, der von einer Frontplatte (105, 105') des Gehäuses (10) nach vorn vorsteht, und wobei der Bedienfeldkörper (310, 310') eine Anzeige (350) umfasst, die so an der Oberseite des Gehäuses (10) positioniert ist, dass sie eine Vorderseite (311) hat, die schräg ist, so dass sie nach oben zeigt;
ein Schubladenfeld (61, 61'), das am Bedienfeld (30, 30') angeordnet ist, wobei das Schubladenfeld (61, 61') eine schräge Seite hat, die in der gleichen Ebene wie die Vorderseite (311) des Bedienfeldkörpers (310, 310') positioniert ist; und
eine Tür (20), die am Gehäuse (10) zum Öffnen bzw. Schließen der Wäscheöffnung (110) montiert ist, wobei die Tür (20) einen Außenrahmen (220) hat, der ein äußeres Erscheinungsbild der Tür (20) bildet,
**dadurch gekennzeichnet, dass**:
der Außenrahmen (220) so positioniert ist, dass wenigstens ein Abschnitt des Außenrahmens (220) zur Außenseite des Gehäuses (10) vorsteht, wenn die Tür (20) geschlossen ist, und
die Tür (20) einen Abschnitt hat, der in einer vertikalen Richtung zur Unterseite des Bedienfeldkörpers (310, 310') zeigt, und ein Spalt (G), der kleiner als eine Höhe des Bedienfeldkörpers (310, 310', 310") ist, zwischen der Tür (20) und dem Bedienfeldkörper (310, 310') ausgebildet ist; und
wobei der Außenrahmen (220) einen Handgriff (220C) umfasst, der am Außenumfang (220B) des Außenrahmens (220) ausgebildet ist, und wobei der Handgriff (220C) eine Vertiefung an der Außenumfangsfläche aufweist, wobei der Handgriff (220C) in der vertikalen Richtung zur Unterseite des Bedienfeldkörpers (310, 310') zeigt.

2. Wäschebehandlungsvorrichtung (1) nach Anspruch 1, wobei ein Aufnahmeabschnitt (140) an der Außenseite der Wäscheöffnung (110) zum Aufnehmen eines Innenrahmens (210) der Tür (20) vorgesehen ist, wobei der Aufnahmeabschnitt (140) von der Vorderseite zur Innenseite des Gehäuses (10) vertieft ist.

3. Wäschebehandlungsvorrichtung (1) nach Anspruch 2, wobei der Innenrahmen (210) eine Form hat, die jener des Aufnahmeabschnitts (140) entspricht.

4. Wäschebehandlungsvorrichtung (1) nach Anspruch 2, wobei der Innenrahmen (210) eine Kreisform hat.

5. Wäschebehandlungsvorrichtung (1) nach Anspruch 2, wobei die Tür (20) ein Türglas (230) umfasst, das zwischen dem Innenrahmen (210) und dem Außenrahmen (220) befestigt ist.

6. Wäschebehandlungsvorrichtung (1) nach Anspruch 2, wobei der Innenrahmen (210) eine Ringform hat und ein Türglas (230) im Inneren des Innenrahmens (210) vorgesehen ist.

7. Wäschebehandlungsvorrichtung (1) nach einem der vorhergehenden Ansprüche, wobei der gesamte Außenrahmen (220) zur Außenseite des Gehäuses (10) freiliegt.

8. Wäschebehandlungsvorrichtung nach einem der vorhergehenden Ansprüche, wobei dann, wenn die Tür (20) geschlossen ist, der Bedienfeldkörper (310, 310', 310") eine größte vorstehende Breite in einer Richtung von vorn nach hinten hat, die im Wesentlichen einer größten vorstehenden Breite in Richtung der Tür (20) von vorn nach hinten gleicht.

## Revendications

1. Appareil de traitement de linge (1) comportant :
une carrosserie (10) ayant une ouverture pour le linge (110) formée dans celle-ci ;
un panneau de commande (30, 30') agencé sur la carrosserie (10), le panneau de commande (30, 30') incluant un corps de panneau de commande (310, 310') faisant saillie vers l'avant à partir d'une plaque avant (105, 105') de la carrosserie (10), et le corps de panneau de commande (310, 310') incluant un affichage (350) positionné sur un côté supérieur de la carrosserie (10) pour avoir un côté avant (311) incliné de manière à être dirigé vers le haut ;
un panneau de tiroir (61, 61') agencé sur le panneau de commande (30, 30'), le panneau de tiroir (61, 61') ayant un côté incliné positionné sur le même plan que le côté avant (311) du corps de panneau de commande (310, 310') ; et
une porte (20) montée sur la carrosserie (10) pour ouvrir/fermer l'ouverture pour le linge (110), dans lequel la porte (20) a un encadrement extérieur (220) qui forme un aspect extérieur de la porte (20),
**caractérisé en ce que** :
l'encadrement extérieur (220) est positionné de telle sorte qu'au moins une partie de l'encadrement extérieur (220) fait saillie vers un extérieur de la carrosserie (10) lorsque la porte (20) est fermée, et
la porte (20) a une partie dirigée vers un côté inférieur du corps de panneau de commande (310, 310') dans une direction verticale et un espace (G) plus petit qu'une hauteur du corps de panneau de commande (310, 310', 310") est formé entre la porte (20) et le corps de panneau de commande (310, 310') ; et
dans lequel l'encadrement extérieur (220) comporte une poignée (220C) formée sur une circonférence extérieure (220B) de l'encadrement extérieur (220), et dans lequel la poignée (220C) comporte un évidement sur la surface circonférentielle extérieure de celle-ci, dans lequel la poignée (220C) est dirigée vers le côté inférieur du corps de panneau de commande (310, 310') dans la direction verticale.

2. Appareil de traitement de linge (1) selon la revendication 1, dans lequel une partie d'appui (140) est prévue sur un extérieur de l'ouverture pour le linge (110) pour mettre en appui un encadrement intérieur (210) de la porte (20) sur celle-ci, la partie d'appui (140) étant évidée vers un intérieur de la carrosserie (10) depuis un côté avant de celle-ci.

3. Appareil de traitement de linge (1) selon la revendication 2, dans lequel l'encadrement intérieur (210) a une forme correspondant à celle de la partie d'appui (140).

4. Appareil de traitement de linge (1) selon la revendication 2, dans lequel l'encadrement intérieur (210) a une forme circulaire.

5. Appareil de traitement de linge (1) selon la revendication 2, dans lequel la porte (20) comporte une vitre de porte (230) couplée entre l'encadrement intérieur (210) et l'encadrement extérieur (220).

6. Appareil de traitement de linge (1) selon la revendication 2, dans lequel l'encadrement intérieur (210) a une forme annulaire et une vitre de porte (230) est prévue sur un intérieur de l'encadrement intérieur (210).

7. Appareil de traitement de linge (1) selon l'une quelconque des revendications précédentes, dans lequel l'encadrement extérieur (220) complet est exposé à un extérieur de la carrosserie (10).

8. Appareil de traitement de linge selon l'une quelconque des revendications précédentes, dans lequel, lorsque la porte (20) est fermée, le corps de panneau de commande (310, 310', 310") a une plus grande largeur projetée dans une direction avant/arrière qui est sensiblement égale à une plus grande largeur projetée dans une direction avant/arrière de la porte (20).
